(19) Europäisches Patentamt
European Patent Office
Office européen des brevets

(11) **EP 1 976 127 A1**

(12) **EUROPEAN PATENT APPLICATION**
published in accordance with Art. 158(3) EPC

(43) Date of publication:
**01.10.2008 Bulletin 2008/40**

(51) Int Cl.:
**H03M 3/02** (2006.01)    **H03F 3/70** (2006.01)
**H03G 3/30** (2006.01)    **H04B 1/16** (2006.01)

(21) Application number: **06833619.7**

(22) Date of filing: **29.11.2006**

(86) International application number:
**PCT/JP2006/323815**

(87) International publication number:
**WO 2007/080715 (19.07.2007 Gazette 2007/29)**

(84) Designated Contracting States:
**DE FR GB**

(30) Priority: **16.01.2006 JP 2006007258**

(71) Applicant: **Pioneer Corporation
Tokyo 153-8654 (JP)**

(72) Inventor: **YAMAMOTO, Yuji
Kawagoe-shi, Saitama 3508555 (JP)**

(74) Representative: **Popp, Eugen
MEISSNER, BOLTE & PARTNER
Postfach 86 06 24
81633 München (DE)**

(54) **DIGITAL RECEPTION DEVICE**

(57)    A digital receiver has a bandpass delta-sigma AD converter for analog-to-digital converting a modulated wave signal in the analog domain to a signal in the digital domain, and an object is a reduction in thermal noise and a reduction in power consumption in the bandpass delta-sigma AD converter.

A signal level detection section 9a detects the level of the IF signal SIF and a current control section 10 are provided. The current control section 10 adjusts, based on the detection result DETa of the signal level detection section 9a, the operating current of an operation amplifier serving as delay means which is a structural component of a switched-capacitor filter 7b provided in the bandpass delta-sigma AD converter 7. As the electric field strength induced in the antenna 1 reduces, the level of the IF signal SIF becomes smaller. The smaller the level of the IF signal SIF, the lower the operating current of the operation amplifier is set, resulting in a reduction in the power consumption. As the electric field strength induced in the antenna 1 increases, the level of the IF signal SIF becomes larger. The larger the level of the IF signal SIF, the higher the operating current of the operation amplifier is set, resulting in a reduction in thermal noise.

FIG.2 (a)

## FIG.2 (b)

## FIG.2 (c)

## FIG.2 (d)

**Description**

**Technical Field**

The present invention relates to a digital receiver for converting a received signal into a digital signal to be processed.

**Background Art**

A digital receiver, which has been developed in recent years, receives incoming radio waves, such as broadcast waves, as a received signal in the analog domain, and then converts the analog signal to a digital signal for detection, demodulation and the like using digital signal processing.

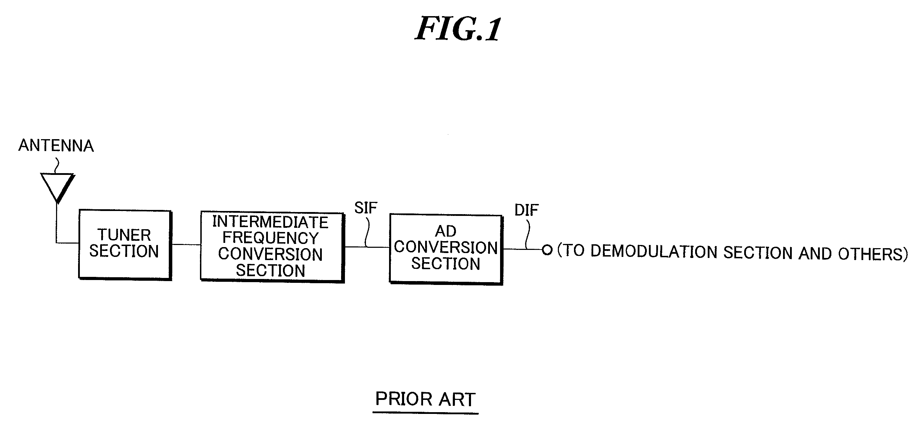

For example, as illustrated in Fig. 1, a conventional digital broadcast receiver for receiving terrestrial digital broadcasts and the like (see Patent Document 1), after having received broadcast waves through an antenna, performs analog signal processing to generate an intermediate frequency (IF) signal SIF through a tuner section (RF amplifier and the like) and an intermediate frequency conversion section (a local oscillator, mixer, band-pass filter, IF amplifier and the like) . Then, the IF signal SIF is analog-to-digital converted to a digital IF signal DIF in the digital domain by an analog-to-digital converter (hereinafter referred to as "AD converter"). Then, the conventional digital broadcast receiver performs digital signal processing for subsequent demodulation and the like after the analog-to-digital conversion.

The AD converter is an absolutely essential component in the formation of the digital receiver. For this reason, the development and research of AD converters have been pursued, and digital receivers using a delta-sigma AD converter or a pipeline AD converter have been devised (see Patent Document 2 and Patent Document 3).

Patent Document 1: Japanese Unexamined Patent application No. 2002-135808
Patent Document 2: Japanese Unexamined Patent application No. 2002-353815
Patent Document 3: Japanese Unexamined Patent application No. 2005-286910

**Disclosure of the Invention**

**Problems to be Solved by the Invention**

In general, important problems to be tackled for achieving an improvement in performance of digital receivers are a reduction in noise and a reduction in power consumption on the part of the AD converter.

For example, the voltage (electric field strength: dB $\mu$V/m) induced in a receiving antenna by an incoming radio wave from a transmitting station varies over a wide dynamic range from one receiving location to another, and the like. For this reason, the AD converter is required to have a wide input dynamic range, in other words, a reduction in noise. In addition, if the battery capacity is limited, as in a mobile receiver, a particular point of importance is a reduction in power consumption of the AD converter which operates at high speed.

In general, low noise and low power consumption of the AD converter have a tradeoff relationship, and cannot be easily achieved together. If an AD converter operating at high current for achieving low noise is designed so that thermal noise is reduced, a reduction in power consumption cannot be achieved. On the other hand, if an AD converter operating at low current for achieving low power consumption is designed, the thermal noise increases, resulting in the impossibility of achieving noise reduction.

The present invention has been made in light of the problems associated with the related art as described above. It is an object of the present invention to provide a digital receiver comprising an AD converter with low noise and low power consumption.

**Means for Solving the Problems**

The invention according to claim 1 provides a digital receiver having a bandpass delta-sigma AD converter for analog-to-digital converting a modulated wave signal in the analog domain to a signal in the digital domain. The digital receiver comprises signal level detection means for detecting the level of the modulated wave signal; and current control means for adjusting, on the basis of the detection result of the signal level detection means, an operating current of an operation amplifier serving as a delay means which is a structural component of a switched-capacitor filter provided in the bandpass delta-sigma AD converter.

**Brief Description of the Drawings**

Fig. 1 is a diagram illustrating the configuration and functions of a conventional digital receiver.

Figs. 2(a) to 2(d) are block diagrams illustrating the configuration of a digital receiver according to each embodiment of the present invention.

Fig.3 is a block diagram illustrating the configuration of a digital receiver according to one example.

Fig.4 is a circuit diagram illustrating the configuration of a bandpass delta-sigma AD converter mounted in the digital receiver in Fig. 3.

Figs. 5(a) and 5(b) are circuit diagrams illustrating the configuration of an operational amplifier and a bias circuit which are structural components of a switched-capacitor filter mounted in the bandpass delta-sigma AD converter in Fig. 4.

**The Best Mode for Carrying Out the Invention**

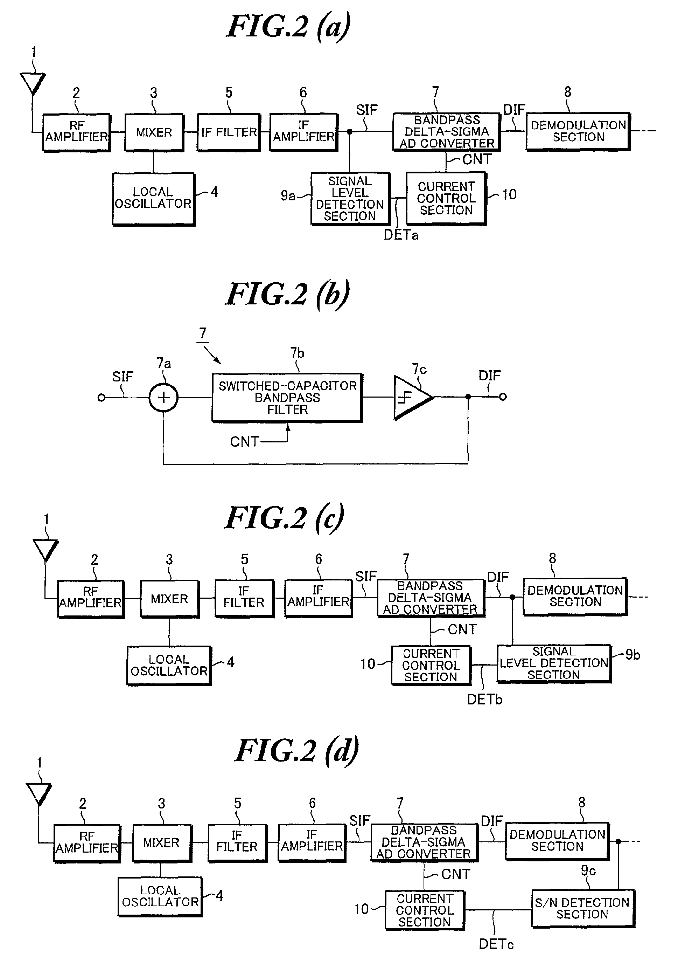

A preferred embodiment of the present invention will be described with reference to Fig. 2(a) to Fig. 2(d).

Fig. 2(a) is a block diagram illustrating the configuration of a digital receiver according to the embodiment.

The digital receiver sends a received signal with high frequencies generated by an antenna 1 receiving an incoming radio wave such as a broadcast wave, to an RF amplifier 2 for amplification. Then, a mixer 3 mixes the amplified received signal with a local oscillator signal (that is, a local oscillator signal generated through station-selection manipulation of the user or the like) which is supplied from a local oscillator 4, so as to frequency-convert the received signal to a signal with intermediate frequencies, which is then sent to an IF filter 5 and an IF amplifier 6 which have a predetermined passband. The IF filter 5 and the IF amplifier 6 extract a desired frequency component (a modulated frequency signal) from the signal with intermediate frequencies and amplifies it to generate an intermediate frequency signal (IF signal) SIF, which is then supplied to a bandpass delta-sigma AD converter 7. The bandpass delta-sigma AD converter 7 converts the IF signal in the analog domain to an IF signal DIF in the digital domain (hereinafter referred to as "digital IF signal DIF") , which is then supplied to a demodulation section 8. The demodulation section 8 performs demodulation on the IF signal DIF in conformance with a broadcast mode so as to generate a demodulated signal. The digital receiver is further equipped with operating current control means having a signal level detection section 9a and a current control section 10.

The signal level detection section 9a performs envelope detection and the like on the amplitude of the IF signal SIF for sequential detection of the level of the IF signal SIF. Then, the signal level detection section 9a supplies a level detection signal DETa indicative of the detected level to the current control section 10.

The current control section 10 determines on the basis of the aforementioned level detection signal DETa the magnitude of the level of the IF signal SIF to measure the magnitude of the electric field strength which is induced in the receiving antenna 1 by the radio wave. That is, because of the correlation between the magnitude of the electric field strength induced in the receiving antenna 1 and the magnitude of the signal level of the IF signal SIF, the magnitude of the signal level of the IF signal SIF, and thus the magnitude of the electric field strength induced in the receiving antenna 1, are determined on the basis of the level detection signal DETa. A control signal CNT is used to adjust the operating current (bias current) of an active bandpass filter which is a structural component of the bandpass delta-sigma AD converter 7. Based on the determined result, the operating current is reduced in accordance with the reduction in the signal level of the IF signal SIF, and is increased in accordance with the increase in the signal level of the IF signal SIF.

As illustrated in Fig. 2(b), the bandpass delta-sigma AD converter 7, of which the operating current is adjustably controlled by the control signal CNT, comprises an adder 7a, a switched-capacitor bandpass filter 7b, which is an active bandpass filter having a passband width adjusted to the band width of the IF signal SIF, and a quantizer 7c. The switched-capacitor filter 7b is formed of a circuit made up of a combination of an operational amplifier (OP amplifier) and a switched capacitor . The adder 7a adds the IF signal SIF and the integral of the digital IF signal DIF generated by the quantizer 7c, together. The switched-capacitor filter 7b passes the sum signal based on the aforementioned passband width and supplies it to the quantizer 7c. As a result, a digital IF signal DIF significantly reduced in quantization noise because of the noise shaping characteristics is output from the quantizer 7c.

The current control section 10 uses, as described above, the control signal CNT to adjust the operating current of the aforementioned operational amplifier (OP amplifier) which is a structural component of the switched-capacitor filter 7b.

As described above, in the digital receiver of the embodiment, the signal level detection section 9a detects the level of the IF signal SIF. Based on the detection result DETa, the current control section 10 determines the electric field strength induced in the antenna 1. The smaller the electric field strength becomes, the lower the operating current of the OP amplifier of the switched-capacitor filter 7b provided in the bandpass delta-sigma AD converter 7 is made by the control of the current control section 10. On the other hand, the greater the electric field strength becomes, the higher the operating current of the OP amplifier is made by the control of the current control section 10. Because of this, the operating current of the OP amplifier is adjusted in accordance with the magnitude of the electric field strength which varies in magnitude over a wide dynamic range, thus making it possible to change the input dynamic range of the bandpass delta-sigma AD converter 7 to correspond to the magnitude of the electric field strength.

In this manner, since, irrespective of the magnitude of the electric field strength which varies over a wide dynamic range, a wide input dynamic range is provided for the purpose of a reduction in thermal noise at all times, the digital receiver of the present embodiment is thus capable of achieving a greater reduction in the power consumption as compared with a conventional digital receiver in which the operating current of the OP amplifier is maintained at high values (is fixed).

In general, when selecting a station for a desired broadcast or the like, the user or the like tunes in to a broadcast or the like that can be received with high quality because of a high electric field strength, and does not tune in to a broadcast or the like when the reception quality is poor because of a low electric field strength. For this reason, in the digital receiver of the present embodiment, when the user or the like tunes in to a desired broadcast or the like, as the level of the IF signal SIF increases, the current control section 10 automatically increases the operating current of the OP amplifier of the switched-capacitor filter 7b in order to increase the input dynamic range of the bandpass delta-sigma AD converter 7. On the other hand, when the user or the like does not tune in to a broadcast or the like, as the level of the IF signal SIF decreases, the current control section 10 automatically decreases the operating current of the OP amplifier of the switched-capacitor filter 7b in order to decrease the input dynamic range of the bandpass delta-sigma AD converter 7.

As a result, the digital receiver of the present embodiment is capable of reducing thermal-noise generation by increasing the operating current of the OP amplifier of the switched-capacitor filter 7b during reception of a broadcast or the like which the user or the like wants to listen to/watch (or receive). On the other hand, when the user or the like does not want to listen to/watch (or receive) , the digital receiver of the present embodiment is capable of achieving a decrease in the power consumption by reducing the operating current of the OP amplifier of the switched-capacitor filter 7b. If the operating current of the OP amplifier of the switched-capacitor filter 7b is decreased when the user of the like does not want to listen to/watch (or receive), an increase in thermal noise is caused. In this case, even if an increase in thermal noise is caused when the user of the like does not want to listen to/watch (or receive) , this will not result in inconveniencing the user or the like.

In this manner, without in effect inconveniencing the user or the like, the digital receiver of the present embodiment adjusts the operating current of the OP amplifier of the switched-capacitor filter 7b for the purpose of reducing thermal-noise generation. In consequence, a reduction in power consumption and a reduction in thermal noise (ensuring a wide input dynamic range) can be achieved together, thus solving the aforementioned related problems.

In the digital receiver of the present embodiment as described above, the level of the IF signal SIF is detected, and then the operating current of the OP amplifier of the switched-capacitor filter 7b is adjusted on the basis of the detection result DETa as shown in Figs. 2 (a) and 2 (b) . As a preferred modification of the present embodiment, as illustrated in Fig. 2(c), the signal level detection section 9b may detect a sample value (that is, a value converted to digital form) of the digital IF signal DIF output from the bandpass delta-sigma AD converter 7, in effect thereby detecting the level of the IF signal SIF. Then, based on the detection result DETb, the current control section 10 may adjust the operating current of the OP amplifier of the aforementioned switched-capacitor filter 7b in the bandpass delta-sigma AD converter for adjustment of the input dynamic range in accordance with the magnitude of the electric field strength induced in the antenna 1.

Even in the configuration of the modification, in this manner the operating current of the OP amplifier of the switched-capacitor filter 7b is adjusted for the purpose of reducing thermal-noise generation without in effect inconveniencing the user or the like. In consequence, a reduction in power consumption and a reduction in thermal noise (ensuring a wide input dynamic range) can be achieved together, thus solving the aforementioned related problems.

As another preferred modification of the present embodiment, as illustrated in Fig. 2(d), an S/N detection section 9c may be provided for detecting a ratio of noise to a signal component (S/N ratio) of a demodulated signal (of which the reference letter is omitted) generated by the demodulation section 8. Then, based on the detection result DETc of the S/N detection section 9c, the current control section 10 may supply a control signal CNT for adjustment of the operating current of the OP amplifier of the aforementioned switched-capacitor filter 7b in the bandpass delta-sigma AD converter. That is, as a result of the detection of the S/N ratio by the S/N detection section 9c, the smaller the S/N ratio, the smaller the electric field strength determined by the current control section 10, so that the current control section 10 decreases the operating current of the OP amplifier of the aforementioned switched-capacitor filter 7b. On the other hand, the larger the S/N ratio, the larger the electric field strength determined by the current control section 10, so that the current control section 10 increases the operating current of the OP amplifier of the aforementioned switched-capacitor filter 7b. Thus, the input dynamic range is set to correspond to the magnitude of the electric field strength.

Even in the configuration of this modification, in this manner the operating current of the OP amplifier of the switched-capacitor filter 7b is adjusted for the purpose of reducing thermal-noise generation without in effect inconveniencing the user or the like. In consequence, a reduction in power consumption and a reduction in thermal noise (ensuring a wide input dynamic range) can be achieved together, thus solving the aforementioned related problems.

The digital receiver of the present embodiment illustrated in Figs. 2 (a) to 2 (d) employs the bandpass delta-sigma AD convert 7 for a desired analog-to-digital conversion. However, the digital receiver may comprises a pipeline AD converter instead of the bandpass delta-sigma AD converter. In the pipeline AD converter, for implementing bit conversion of the MSB through the LSB in a plurality of stages, an operational amplifier (OP amplifier), which is a structural component of each stage, quantizes an error signal generated between a sub AD converter and a sub DA converter for the bit conversion. The operating current of the operation amplifier (OP amplifier) may be controlled by operating current control means comprising either signal level detection section 9a or 9b, shown in Figs. 2(a) and 2(b), and the current control section 10. Alternatively, the operating current of the operation amplifier (OP amplifier) may be controlled by operating current control means comprising the S/N detection section 9c shown in Fig. 2(c) and the current control section 10.

**Example**

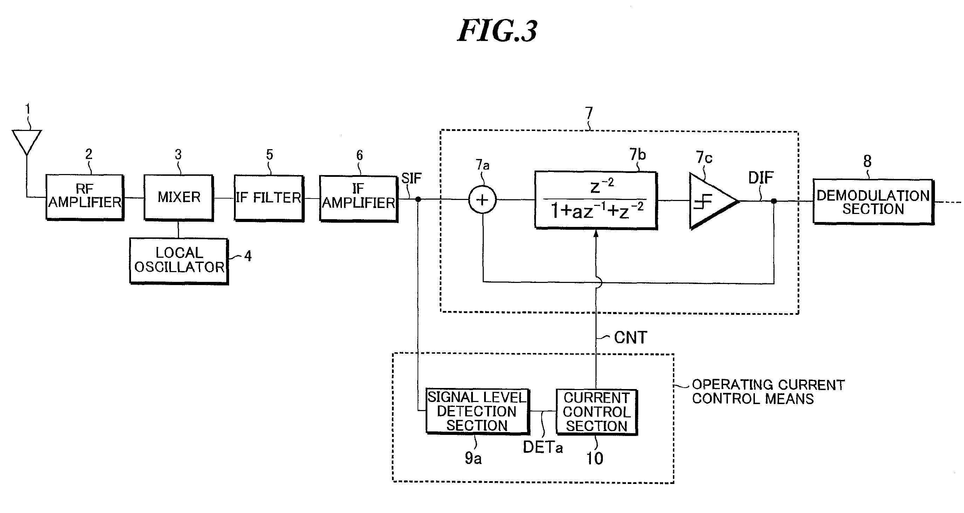

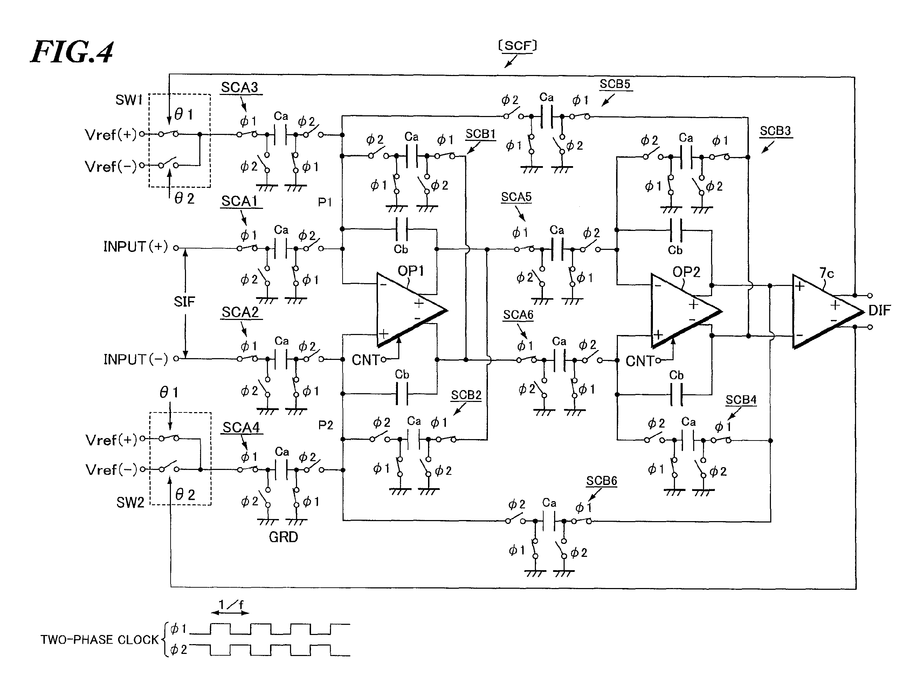

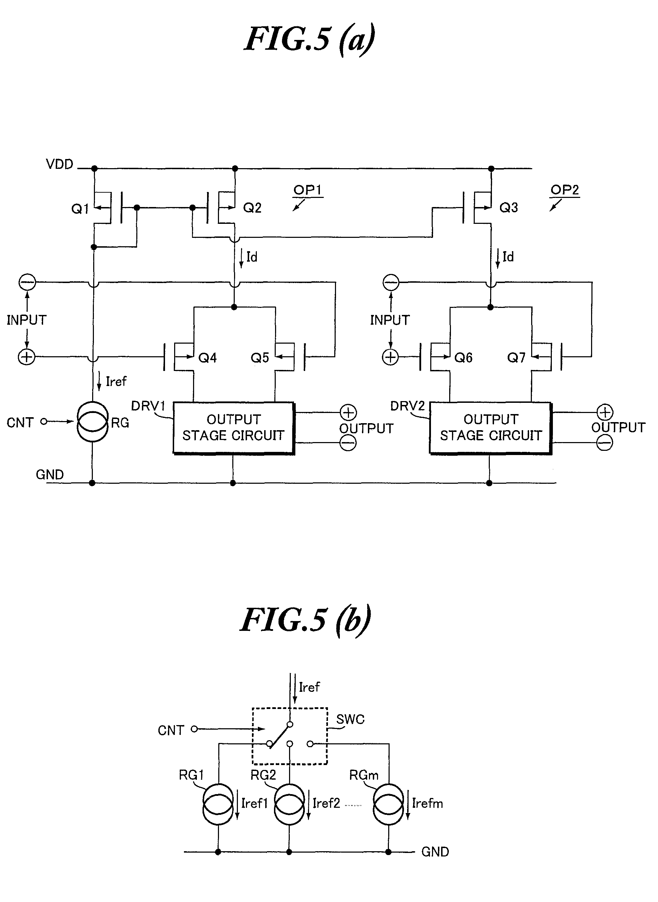

Next, a further specific example of the embodiment will be described with reference to Fig. 3 to Figs. 5(a), 5 (b). Fig. 3 is a block diagram illustrating the configuration of the digital receiver of the example. Fig. 4 is a circuit diagram illustrating the configuration of the bandpass delta-sigma AD converter. Figs. 5 (a) and 5(b) are circuit diagrams illustrating the configuration of an operation amplifier (OP amplifier) included in a switched-capacitor filter. In Fig. 3 to Figs. 5 (a) , 5 (b) the components, which are the same as or equivalent to those in Figs. 2 (a) and 2 (b), are designated by the same reference numerals as those in Figs. 2(a) and 2(b).

In Fig. 3, as in the case of the configuration of Fig. 2(a), the digital receiver of the example comprises an antenna 1 receiving an incoming radio wave, a local oscillator 4 outputting a local oscillator signal in response to station-selection manipulation of the user or the like, a mixer 3 for frequency conversion of the received signal to a signal with intermediate frequencies, an IF filter 5 and an IF amplifier 6 which extract a desired frequency component with a predetermined bandwidth and amplify it, a bandpass delta-sigma AD converter 7, and a demodulation section 8. The IF signal SIF output from the IF amplifier 6 is supplied to the bandpass delta-sigma AD converter 7, thereby being analog-to-digital converted to a digital IF signal DIF, which is then supplied to the demodulation section 8.

In addition, the digital receiver comprises operating current control means having a signal level detection section 9a and a current control section 10. The signal level detection section 9a receives the IF signal SID and performs envelope detection on it to produce an envelope signal of the IF signal SIF. The level (amplitude) of the envelop signal is sequentially detected as the level of the IF signal SIF. Then, the signal level detection section 9a outputs a level detection signal DETa which is the detection result. From the level detection signal DETa, the current control section 10 determines the level of the IF signal SIF, and then outputs a control signal CNT indicative of the determined level of the IF signal SIF.

The bandpass delta-sigma AD converter 7 comprises an adder (analog adder) 7a, a switched-capacitor bandpass filter 7b, which is an active bandpass filter having a predetermined passband width, and a quantizer 7c. The adder 7a adds the IF signal SIF and the integral of the output (digital IF signal) DIF of the quantizer 7c, together, and then supplies the result to the switched-capacitor filter 7b. The switched-capacitor filter 7b filters the sum signal based on a transfer function H(z) in z transform notation expressed by the following equation (1). Then, the signal subjected to the filtering is quantized by the quantizer 7c, thus outputting a digital IF signal.

[Equation 1]

$$H(z) = \frac{z^{-2}}{1 + az^{-1} + z^{-2}} \qquad \cdots (1)$$

In this regard, the transfer function H(z) has second-order bandpass filter characteristics, of which the passband width is adjusted to the bandwidth of the IF signal SIF. For this reason, the following equation (2) is written when the IF signal SIF, the digital IF signal DIF and the quantization noise generated in the quatizer 7c are respectively represented as SIF(z), DIF(z) and Q(z) in z-transform notation. The quantization noise Q (z) experiences noise shaping $(1+az^{-1}+z^{-2})$ , thus producing a digital IF signal DIF(z) with a satisfactory S/N ratio.

[Equation 2]

$$DIF(z) = SIF(z) \cdot z^{-2} + Q(z) \cdot (1 + az^{-1} + z^{-2}) \qquad \cdots (2)$$

Further, a specific circuit of the bandpass delta-sigma AD converter 7 will be described with reference to Fig. 4. The bandpass delta-sigma AD converter 7 has a double balanced switched-capacitor filter (indicated by reference letters SCF) which receives the IF signal SIF supplied from the IF amplifier 6, and the quantizer (comparator) 7c which quantizes the output of the double balanced switched-capacitor filter SCF. In addition, the double balanced switched-capacitor filter SCF has also the configuration of the aforementioned adder 7a and switched-capacitor filter 7b.

Specifically, a first-stage one-sample delay circuit is made up of four switched-capacitor circuits SCA1, SCA2, SCB1 and SCB2, an OP amplifier OP1, and two feedback capacitors Cb to connected input and output terminals of the OP amplifier OP1. A second-stage one-sample delay circuit is made up of four switched-capacitor circuits SCA5, SCA6, SCB3 and SCB4, an OP amplifier OP2, and two feedback capacitors Cb connected to input and output terminals of the OP amplifier OP2. In addition, feedback paths are made up of switched-capacitor circuits SCB5, SCB6 connected between the output terminals of the OP amplifier OP2 and the input terminals of the OP amplifier OP1. The double balanced switched-capacitor filter SCF comprises two switch circuits SW1, SW2 that receive a predetermined positive reference voltage Vref(+) or a predetermined negative reference voltage Vref (-) after switching between them in accordance with output signals θ1, θ2 which are indicative of a phase of the digital IF signal DIF produced between the balanced output terminals of the quantizer 7c. The double balanced switched-capacitor filter SCF is further provided with two switched capacitor circuits SCA 3, SCA 4 for transferring the reference voltage Vref (+) or Ref (-), which is received through the switch circuits SW1, SW2, to the input terminals of the OP amplifier OP1.

Each of the switched-capacitor circuits SCA1 to SCA6 and SCB1 to SCB6 is made up of four switch elements and a capacitor with a capacitance Ca. In synchronization with two-phase clock signals φ1, φ2 which repeat logical inversion relative to each other at higher frequency (that is, over-sampling frequency) than the frequency of the IF signal SIF, the switch elements of each of the switched-capacitor circuits SCA1 to SCA6 and the switch elements of each of the switched-capacitor circuits SCB1 to SCB6 repeat the on/off operation at exclusive time, so that the input signal is transferred through the capacitor with the capacitance Ca.

In such configuration, the input end P1 of the inverted input terminal (-) of the OP amplifier OP1 and the input end P2 of the non-inverted input terminal (+) fulfill the function as the adder 7a which is established by wired connection. In addition, the switched-capacitor circuits SCA3, SCB5 and the switched-capacitor circuits SCA4, SCB6 which are connected to the input ends P1 and P2 fulfill the function as the feedback path for performing integration on the digital IF signal DIF which is the output of the quantizer 7c, to the adder 7a and then returning the result to the adder 7a. In addition, the four switched-capacitor circuits SCA1, SCA2, SCB1 and SCB2, the OP amplifier OP1, and the two feedback capacitors Cb each connected to the input and output terminals of the OP amplifier OP1 form a first-stage one-sample delay circuit (that is, a delay circuit for delaying the input IF signal SIF by one sample delay ($z^{-1}$) and then outputting it). The four switched-capacitor circuits SCA5, SCA6, SCB3 and SCB4, the OP amplifier 2, and the two feedback capacitors Cb connected to the input and output terminals of the OP amplifier OP2 form a second-stage one-sample delay circuit (that is, a delay circuit for delaying the output from the first-stage one-sample delay circuit by one sample delay ($z^{-1}$) and then outputting it).

In this manner, the double-balanced switched-capacitor filter SCF shown in Fig. 4, and the quantizer (comparator) 7c for quantizing the output of the double-balanced switched-capacitor filter SCF form the bandpass delta-sigma AD converter 7 shown in Fig. 3.

Next, the OP amplifiers OP1 and OP2, which are structural components of the one sample delay circuits in the respective stages, have the circuit configuration illustrated in Fig. 5(a).

Specifically, a bias circuit for generating operating currents Id for the OP amplifiers OP1 and OP2 is made up of transistors Q1, Q2 and Q3 which form a current mirror circuit connected to the power supply line VDD, and a variable current source circuit RG connected between the grind line GND and the transistor Q1 connected as a diode. The mirror current Id generated by the transistor Q2 is supplied to a differential pair of transistors Q4 and Q5 which are structural components of the OP amplifier OP1, and to the output stage circuit DRV1 as the operating current. The mirror current Id generated by the transistor Q3 is supplied to a differential pair of transistors Q6 and Q7 which are structural components of the OP amplifier OP2, and to the output stage circuit DRV2 as the operating current.

Then, the variable current source circuit RG changes the reference current Iref in accordance with the control signal CNT from the current control section shown in Fig. 3, in order to adjust the operating currents Id respectively supplied to the OP amplifiers OP1 and OP2. In this connection, the maximum adjustable range (span) of the reference current Iref by the variable current source circuit RG is related with the maximum change range from the maximum electric field strength induced in the antenna 1 when the reception quality is best and the maximum level of the IF signal SIF at this point of time, to the minimum electric field strength induced in the antenna 1 when the reception quality is not best and the minimum level of the IF signal SIF at this point of time, that is, with the maximum change range of the IF signal SIF corresponding to the dynamic range of the electric field strength. Then, the resolution of the variable current source circuit RG for the control signal CNT is previously determined such that the reference current Iref is generated corresponding to the control signal CNT indicative of the level of the actually detected IF signal SIF.

Next, a description will be given of the operation of the digital receiver of the example having configuration as described above.

When the user or the like selects a station for a desired broadcast or the like that can be received with high quality, an IF signal SIF is output at a high level in accordance with the electric field strength induced in the antenna 1 and supplied from the IF amplifier 6 to the bandpass delta-sigma AD converter 7. As well, the signal level detection section 9a detects the level of the IF signal SIF, and then the current control section 10 supplies a control signal CNT indicative of the detection result DETa to the variable current source circuit RG (see Fig. 5(a)). As a result, a reference current Iref having a large current value corresponding to the electric field strength induced in the antenna 1 is generated, and the operating currents Id having a large current value proportional to the reference current Iref are respectively supplied to the OP amplifiers OP1 and OP2 through the transistors Q2 and Q3. For this reason, the bandpass delta-sigma AD converter 7 is reduced in thermal noise and set in a wide input dynamic range.

Next, when the user or the like does not select a station for a desired broadcast or the like that can be received with high quality, an IF signal SIF is output at a low level in accordance with the electric field strength induced in the antenna 1 and supplied from the IF amplifier 6 to the bandpass delta-sigma AD converter 7. As well, the signal level detection section 9a detects the level of the IF signal SIF, and then the current control section 10 supplies a control signal CNT indicative of the detection result DETa to the variable current source circuit RG (see Fig. 5(a)). As a result, a reference current Iref having a small current value corresponding to the electric field strength induced in the antenna 1 is generated, and the operating currents Id having a small current value proportional to the reference current Iref are respectively supplied to the OP amplifiers OP1 and OP2 through the transistors Q2 and Q3. For this reason, the bandpass delta-sigma AD converter 7 is increased in thermal noise and has a small input dynamic range. However, when the user or the like cannot receive the broadcast with high quality, the user of the like does not want to listen to/watch (or receive) . For this reason, even if an increase in thermal noise is caused, this will not result in inconveniencing the user or the like. An effect on a reduction in the operating currents Id, that is, a profound effect on a reduction in the power consumption can be achieved.

As described above, without in effect inconveniencing the user or the like, the digital receiver of the present example adjusts the operating currents Id of the respective OP amplifiers OP1, OP2 of the switched-capacitor filter 7b for the purpose of reducing thermal-noise generation. In consequence, a reduction in power consumption and a reduction in thermal noise (ensuring a wide input dynamic range) can be achieved together, thus solving the aforementioned related problems.

The digital receiver of the present example as described above is designed to detect the level of the IF signal SIF and then adjust the operating currents Id of the respective OP amplifiers OP1, OP2 of the switched-capacitor filter 7b on the basis of the detection result. As a modification of the present example, the signal level detection section 9b may be provided as illustrated in Fig. 2(c). The signal level detection section 9b may detect a sample value (that is, a value converted to digital form) of the digital IF signal DIF output from the bandpass delta-sigma AD converter 7, in effect thereby detecting the level of the IF signal SIF. Then, based on the detection result DETb, the current control section 10 may adjust the reference current Iref of the variable current source circuit RG for adjustment of the operating currents Id of the respective OP amplifiers OP1, OP2 of the switched-capacitor filter 7b.

Even in the configuration of the modification, in this manner the operating currents Id of the respective OP amplifiers OP1, OP2 of the switched-capacitor filter 7b are adjusted for the purpose of reducing thermal-noise generation without in effect inconveniencing the user or the like. In consequence, a reduction in power consumption and a reduction in thermal noise (ensuring a wide input dynamic range) can be achieved together, thus solving the aforementioned related problems.

As another modification of the present example, as illustrated in Fig. 2 (d) , an S/N detection section 9c may be provided for detecting a ratio of noise to a signal component (S/N ratio) of a demodulated signal (of which the reference letter is omitted) generated by the demodulation section 8. Then, based on the detection result DETc of the S/N detection section 9c, the current control section 10 may use a control signal CNT to adjust the reference current Iref of the variable current source circuit RG for adjustment of the operating currents Id of the respective OP amplifiers OP1, OP2 of the switched-capacitor filter 7b. That is, as a result of the detection of the S/N ratio by the S/N detection section 9c, the smaller the S/N ratio, the smaller the electric field strength determined by the current control section 10. Thus, the current control section 10 may adjust the reference current Iref of the variable current source circuit RG to a small current value for adjustment of the operating currents Id of the respective OP amplifiers OP1, OP2 of the switched-capacitor filter 7b to a small current value. On the other hand, the larger the S/N ratio, the larger the electric field strength determined by the current control section 10. Thus, the current control section 10 may adjust the reference current Iref of the variable current source circuit RG to a large current value for adjustment of the operating currents Id of the respective OP amplifiers OP1, OP2 of the switched-capacitor filter 7b to a large current value.

Even in the configuration of this modification, in this manner the operating currents Id of the respective OP amplifiers OP1, OP2 of the switched-capacitor filter 7b are adjusted for the purpose of reducing thermal-noise generation without in effect inconveniencing the user or the like. In consequence, a reduction in power consumption and a reduction in thermal noise (ensuring a wide input dynamic range) can be achieved together, thus solving the aforementioned related problems.

The bias circuit illustrated in Fig. 5(a) is designed to use a single variable current source RG to change the reference current Iref . However, as illustrated in Fig. 5(b), m constant current source circuits RG1, RG2, ....., RGm are provided for respectively generating constant currents Iref1, Iref2, ....., Irefm which differ from each other within the maximum adjustable region (span) of the reference current Iref. The constant current source circuits RG1, RG2, ....., RGm can be connected through a selector switch element SWC to the transistor Q1 of the mirror circuit. The selector switch element SWC may be switch-controlled, so that the transistor Q1 of the mirror circuit is connected to one constant current source circuit of the constant current source circuits RG1, RG2, ............, RGm which generates a constant current corresponding to the level of the IF signal SIF represented by the control signal CNT or a constant current corresponding to the S/N of the digital IF signal DIF represented by the control signal CNT, thus adjusting the reference current Iref.

## Claims

1. A digital receiver having a bandpass delta-sigma AD converter for analog-to-digital converting a modulated wave signal in the analog domain to a signal in the digital domain, comprising:

   signal level detection means for detecting the level of said modulated wave signal; and
   current control means for adjusting, on the basis of the detection result of said signal level detection means, an operating current of an operation amplifier serving as a delay means which is a structural component of a switched-capacitor filter provided in said bandpass delta-sigma AD converter.

2. The digital receiver according to claim 1,
   wherein said signal level detection means detects the level of the modulated wave signal by detecting a level of the signal in said digital domain after being digitized by said bandpass delta-sigma AD converter.

3. The digital receiver according to claim 1,
   wherein said signal level detection means detects the level of said modulated wave signal by detecting an S/N ratio of a demodulated signal generated by demodulation means for demodulating the signal in said digital domain after being digitized by said bandpass delta-sigma AD converter.

4. The digital receiver according to any one of claims 1 to 3, comprising a current source circuit and a mirror circuit that generates said operating current proportional to a reference current generated by said current source circuit, wherein said current control means adjusts said reference current of said current source circuit on the basis of said detection result of the said signal level detection means.

# FIG.1

ANTENNA

TUNER SECTION → INTERMEDIATE FREQUENCY CONVERSION SECTION → SIF → AD CONVERSION SECTION → DIF → O (TO DEMODULATION SECTION AND OTHERS)

PRIOR ART

EP 1 976 127 A1

## FIG.2 (a)

```
1
  ▽
        2              3            5          6        SIF      7            DIF     8
     ┌────────┐   ┌────────┐  ┌────────┐ ┌────────┐      ┌──────────────┐      ┌──────────────┐
     │   RF   │   │        │  │   IF   │ │   IF   │      │  BANDPASS    │      │ DEMODULATION │
     │AMPLIFIER│──│ MIXER  │──│ FILTER │─│AMPLIFIER│──┬──│ DELTA-SIGMA  │──────│   SECTION    │───
     └────────┘   └───┬────┘  └────────┘ └────────┘  │   │ AD CONVERTER │      └──────────────┘
                      │                               │   └──────┬───────┘
                  ┌────────┐                          │        ┌─┘ CNT
                  │ LOCAL  │                          │   ┌──────────┐  ┌──────────┐
                  │OSCILLATOR│─4                       │   │  SIGNAL  │  │ CURRENT  │
                  └────────┘                      9a──┼───│  LEVEL   │  │ CONTROL  │─10
                                                       │   │DETECTION │  │ SECTION  │
                                                       └───│ SECTION  │  └──────────┘
                                                           └──────────┘
                                                                └─── DETa
```

## FIG.2 (b)

```
                          7
              7a       ↙       7b
    SIF      ╱─╲          ┌────────────────┐          7c
   ○───────│ + │─────────│ SWITCHED-CAPACITOR│       ╱│         DIF
            ╲─╱          │    BANDPASS     │──────│ ╫ │──────○
             ▲           │     FILTER      │       ╲│    │
             │           └────────┬────────┘            │
             │              CNT───┘                     │
             └────────────────────────────────────────┘
```

## FIG.2 (c)

```
1
  ▽
        2              3            5          6        SIF      7            DIF     8
     ┌────────┐   ┌────────┐  ┌────────┐ ┌────────┐      ┌──────────────┐      ┌──────────────┐
     │   RF   │   │        │  │   IF   │ │   IF   │      │  BANDPASS    │      │ DEMODULATION │
     │AMPLIFIER│──│ MIXER  │──│ FILTER │─│AMPLIFIER│──────│ DELTA-SIGMA  │──┬───│   SECTION    │───
     └────────┘   └───┬────┘  └────────┘ └────────┘      │ AD CONVERTER │  │   └──────────────┘
                      │                                   └──────┬───────┘  │
                  ┌────────┐                                   ┌─┘ CNT      │
                  │ LOCAL  │                            ┌──────────┐  ┌──────────────┐
                  │OSCILLATOR│─4                          │ CURRENT  │  │   SIGNAL     │
                  └────────┘                      10──│ CONTROL  │  │LEVEL DETECTION│─9b
                                                       │ SECTION  │  │   SECTION     │
                                                       └──────────┘  └──────────────┘
                                                              └─── DETb
```

## FIG.2 (d)

```
1
  ▽
        2              3            5          6        SIF      7            DIF     8
     ┌────────┐   ┌────────┐  ┌────────┐ ┌────────┐      ┌──────────────┐      ┌──────────────┐
     │   RF   │   │        │  │   IF   │ │   IF   │      │  BANDPASS    │      │ DEMODULATION │
     │AMPLIFIER│──│ MIXER  │──│ FILTER │─│AMPLIFIER│──────│ DELTA-SIGMA  │──────│   SECTION    │──┬─
     └────────┘   └───┬────┘  └────────┘ └────────┘      │ AD CONVERTER │      └──────────────┘  │
                      │                                   └──────┬───────┘                        │
                  ┌────────┐                                   ┌─┘ CNT                   9c        │
                  │ LOCAL  │                            ┌──────────┐              ┌──────────────┐│
                  │OSCILLATOR│─4                          │ CURRENT  │              │S/N DETECTION ││
                  └────────┘                      10──│ CONTROL  │              │   SECTION     ││
                                                       │ SECTION  │              └──────────────┘│
                                                       └──────────┘                              │
                                                              └─── DETc
```

11

*FIG.3*

# FIG.4

TWO-PHASE CLOCK $\begin{cases} \phi 1 \\ \phi 2 \end{cases}$

EP 1 976 127 A1

## FIG.5 (a)

## FIG.5 (b)

## INTERNATIONAL SEARCH REPORT

| International application No. |
| --- |
| PCT/JP2006/323815 |

A. CLASSIFICATION OF SUBJECT MATTER
*H03M3/02*(2006.01)i, *H03F3/70*(2006.01)i, *H03G3/30*(2006.01)i, *H04B1/16* (2006.01)i

According to International Patent Classification (IPC) or to both national classification and IPC

B. FIELDS SEARCHED

Minimum documentation searched (classification system followed by classification symbols)
H03M3/02, H03F3/70, H03G3/30, H04B1/16

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2003-124813 A (Asahi Kasei Microsystems Co., Ltd.), 25 April, 2003 (25.04.03), Par. Nos. [0019] to [0043]; Figs. 1, 2 (Family: none) | 1-4 |
| A | JP 2005-72632 A (Renesas Technology Corp.), 17 March, 2005 (17.03.05), Full text; all drawings (Family: none) | 1-4 |
| A | JP 2005-198033 A (Seiko Clock Inc.), 21 July, 2005 (21.07.05), Par. Nos. [0021] to [0070]; Figs. 1, 2 (Family: none) | 1,2 |

| ☒ Further documents are listed in the continuation of Box C. | ☐ See patent family annex. |
| --- | --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| 15 December, 2006 (15.12.06) | 26 December, 2006 (26.12.06) |

| Name and mailing address of the ISA/ Japanese Patent Office | Authorized officer |
| --- | --- |
| Facsimile No. | Telephone No. |

Form PCT/ISA/210 (second sheet) (April 2005)

**INTERNATIONAL SEARCH REPORT**

| International application No. |
| --- |
| PCT/JP2006/323815 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 11-163731 A  (Yamaha Corp.),<br>18 June, 1999 (18.06.99),<br>Par. Nos. [0022] to [0027]; Figs. 1, 3<br>& US 6445320 B1 | 4 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002135808 A
- JP 2002353815 A
- JP 2005286910 A